# EUROPEAN PATENT APPLICATION

(11) **EP 1 505 665 A2**
(43) Date of publication of application: **09.02.2005**
(21) Application number: 04017850.1
(22) Date of filing: 28.07.2004
(51) Int. Cl.: H01L 51/20

(54) **Organic electroluminescence device**

(30) Priority: 29.07.2003 JP 2003281887
(71) Applicant: Kabushiki Kaisha Toyota Jidoshokki, Kariya-shi, Aichi-ken (JP)
(72) Inventor: Maeda, Shoichi, Kariya-shi Aichi-ken (JP)
(74) Representative: Leson, Thomas Johannes Alois, Dipl.-Ing.

(57) **Abstract**

A thin organic EL device (11) having improved heat radiation characteristics. A transparent electrode (13), an organic EL layer (14), and a metal second electrode (15) are sequentially superimposed on a glass substrate (12). A plurality of projections (19) extend from the upper surface of the second electrode. A protective film (16) protecting the organic EL layer from oxygen and moisture is in close contact with the second electrode. A conductive film (17), which is insulated from the second electrode, includes a first end portion and a second end portion connected to the first electrode.

## Description

The present invention relates to organic electroluminescence (EL) devices.

Organic EL devices have received much attention for use as a display device or a thin luminescence device. A typical organic EL device includes a transparent electrode (anode), which is made of indium tin oxide (ITO) and formed on a glass substrate, an organic EL layer, which has a luminescence layer formed on the transparent electrode, and a cathode, which is formed on the organic EL layer. The luminescence layer generates light that is emitted from the glass substrate.

The organic EL layer is normally vulnerable to moisture and oxygen. Thus, a shielding cover is bonded to the substrate with an adhesive agent to protect the organic EL layer from moisture and oxygen. The organic EL layer and the cathode are accommodated in the sealed space defined between the shielding cover and the substrate. The sealed space is filled with inert gas, such as nitrogen and argon, or inert fluid.

Drive voltage is applied between the anode and the cathode so that current flows through the organic EL layer between the anode and the cathode to emit light from the electroluminescence layer. The current heats the organic EL layer. The shielding cover has a shortcoming in that it interferes with the radiation of heat from the organic EL device.

A first prior art example that solves this problem is described in Japanese Laid-Open Patent Publication No. 2003-22891. Referring to Fig. 5, the publication describes an organic EL display device 41, which includes a glass substrate 43. A plurality of electrodes 42 are formed on the glass substrate 43. An organic EL layer 44 is superimposed on the glass substrate 43. The organic EL display device 41 further includes an upper electrode 45 facing towards the glass substrate 43. A sealing plate 48 is bonded to the substrate 43 by a seal 47. A sealed space 46 is defined between the sealing plate 48 and the substrate 43. A plurality of polygonal projections 49 project toward the sealing plate 48 from the upper electrode 45 in the sealed space 46.

A second prior art example is described in US Patent No. 5,821,692. Referring to Fig. 6, the publication describes an organic EL device 50, which has a shielding cover 54 including fins 56. A transparent electrode 52 is formed on a transparent substrate 51. The shielding cover 54 is attached to the transparent electrode 52 to cover an organic EL array 53. Liquid 55 is charged into the shielding cover 54.

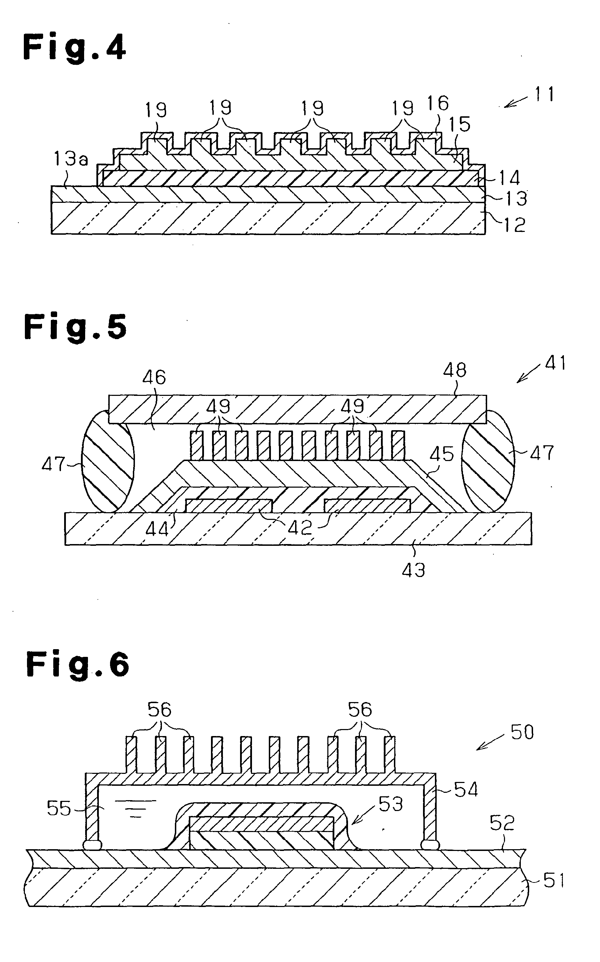

In the organic EL display device 41 of Fig. 5, the heat radiated from the projections 49 heats the gas in the sealed space 46. However, the heated gas is not released from the sealed space 46. Thus, the heat radiation effect is insufficient. Further, the necessity for the sealed space 46 makes it difficult to produce a thinner organic EL display device 41.

In the organic EL device 50 of Fig. 6, the heat of the organic EL array 53 is conducted to the shielding cover 54 via the liquid 55. However, the charging of liquid into the shielding cover 54 is burdensome. Further, the necessity of the shielding cover 54 makes it difficult to produce a thinner organic EL device 50.

The intensity of the light emitted from an organic EL device (luminescent brightness) is proportional to the amount of current flowing between the anode and cathode. Further, the resistance of the material forming the transparent electrode is greater than that of the material forming a metal electrode. Accordingly, the electric resistance value and current value differs between a location near an electrode terminal and a location far from an electrode terminal. The difference between the current values causes the brightness to differ at different positions in the organic EL device.

To minimize differences in the luminescent brightness, a metal auxiliary electrode connected to an anode terminal may be arranged in a peripheral portion of a transparent electrode.

The inventor of the present invention has recognized that when the radiation of heat from the organic EL layer is insufficient, the difference between the resistance of the material forming a transparent electrode and the resistance of material forming an auxiliary electrode tends to cause brightness unevenness. Accordingly, it is an object of the present invention to provide a thin organic EL device having even brightness.

To achieve the above object, the present invention provides an organic electroluminescence device including a substrate for transmitting visible light. A first electrode is superimposed on the substrate to transmit visible light. An organic electroluminescence layer is superimposed on the first electrode. A second electrode is superimposed on the organic electroluminescence layer. The second electrode includes a first surface facing towards the organic electroluminescence layer, a second surface facing away from the organic electroluminescence layer, and at least either one of a plurality of projections or a plurality of recesses arranged along the second surface. A protective film, covering the second electrode, protects the organic electroluminescence layer.

Other aspects and advantages of the present invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1A is a plan view of an organic EL device according to a first embodiment of the present invention;
Fig. 1B is a schematic cross-sectional view of the organic EL device taken along line 1B-1B in Fig. 1A;
Fig. 1C is a schematic cross-sectional view of the organic EL device taken along line 1C-1C in Fig. 1B;
Fig. 2A is a schematic diagram showing the arrangement of a first electrode and a connection terminal;
Fig. 2B is a perspective view showing a second electrode and projections;
Fig. 3 is a cross-sectional view of an organic EL device according to a second embodiment of the present invention;
Fig. 4 is a cross-sectional view of an organic EL device according to a further embodiment of the present invention;
Fig. 5 is a cross-sectional view showing a first prior art example of an organic EL device; and
Fig. 6 is a cross-sectional view showing a second prior art example of an organic EL device.

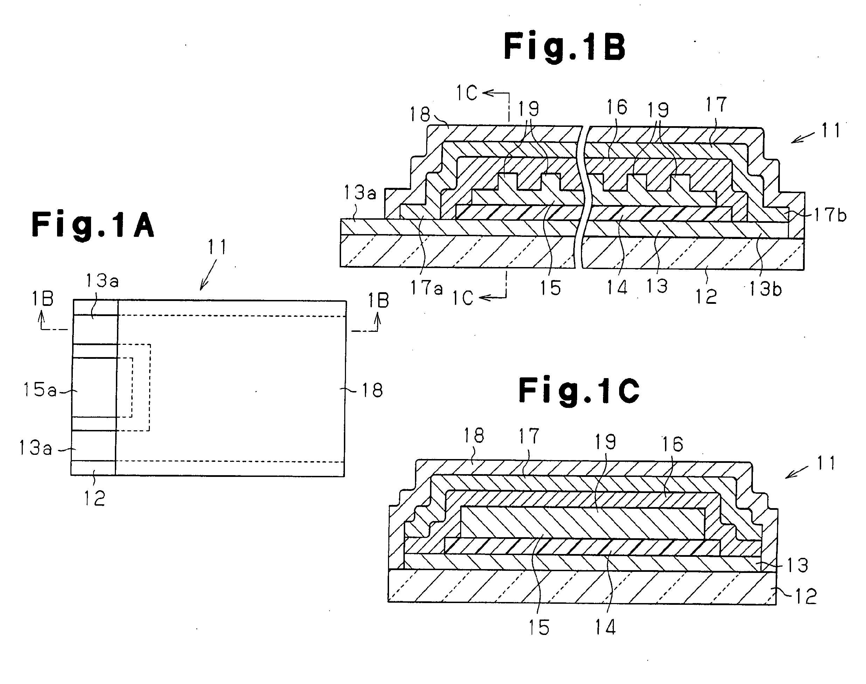

An organic electroluminescence (EL) device 11 according to a first embodiment of the present invention will now be discussed. The relative dimensions of the parts shown in Figs. 1A to 2B differ from the actual dimensions.

Referring to Figs. 1A to 1C, the organic EL device 11 includes a first electrode 13, an organic EL layer 14, and a second electrode 15, which are superimposed on a glass substrate 12. The second electrode 15 and the organic EL layer 14 are covered by a protective film 16. The protective film 16 protects the organic EL layer 14 from oxygen and moisture. The glass substrate 12 and the first electrode 13 are transparent and permit the transmission of visible light. The organic EL layer 14 generates light that is emitted from the glass substrate 12. Accordingly, the organic EL device 11 is a so-called bottom emission type device.

The first electrode 13 functions as an anode, and the second electrode 15 functions as a cathode. The first electrode 13, the organic EL layer 14, and the second electrode 15 are each flat and rectangular. To prevent short-circuiting between the first electrode 13 and the second electrode 15, the area of the upper surface of the organic EL layer 14 is greater than that of the lower surface of the second electrode 15.

The protective film 16 covers the surfaces of the first electrode 13, the organic EL layer 14, and the second electrode 15 except for the surfaces located between these members. The protective film 16 is formed by coating material that inhibits the transmission of at least moisture (water vapor) and oxygen. For example, polysilazane may be used as the material of the protective film 16. Polysilazane is a fluid material that converts to silica under normal temperatures after it is coated. In this case, the protective film 16 is formed by applying fluid material and then solidifying the fluid material.

A conductive film 17 is formed on the protective film 16. The conductive film 17 is insulated from the second electrode 15. Further, the conductive film 17 is formed from a material having resistivity that is less than that of the material forming the first electrode 13. In the first embodiment, the conductive film 17 is an aluminum vapor deposition film. When viewing the glass substrate 12 from above, the conductive film 17 has substantially the same shape as the first electrode 13. The conductive film 17 has a first end portion 17a, which is connected to a first end of first connection terminals 13a of the first electrode 13, and a second end portion 17b, which is connected to a second end 13b of the first electrode 13 on the opposite side of the first end. An insulation film 18, made of the same material as the protective film 16, covers the conductive film 17.

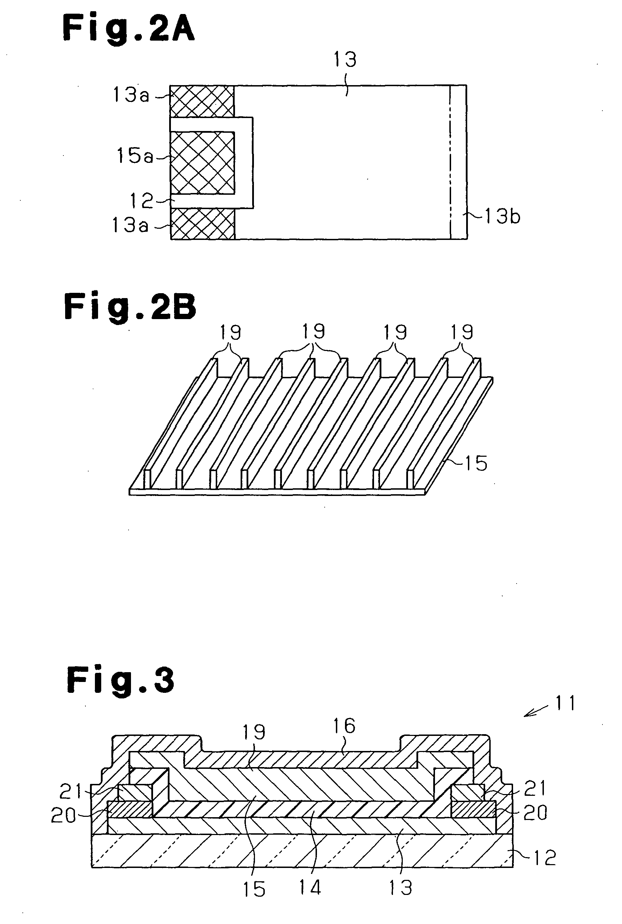

The first electrode 13, the first connection terminals 13a, and a second connection terminal 15a are formed by patterning a transparent conductive layer, made of a material such as ITO and formed on the substrate 12, and then eliminating parts of the transparent conductive layer. As shown in Fig. 2A, the first connection terminals 13a, which is indicated by meshed portions, is formed continuously from the first electrode 13. The second connection terminal 15a is separated from the first connection terminals 13a and the first electrode 13.

The organic EL layer 14 may have a structure that is known in the art. For example, from the side closer to the first electrode 13, the organic EL layer 14 may be three layers, which are a hole injection layer, a luminescence layer, and an electron injection layer, or four layers, which are a hole injection layer, a hole transport layer, a luminescence layer, and an electron transport layer. The organic EL layer emits white light.

A metal that reflects light, such as aluminum or aluminum alloy, may be used as the material for the second electrode 15. A plurality of projections 19 are formed on the upper surface of the second electrode 15, or the surface of the second electrode 15 facing away from the organic EL layer 14. The projections 19 function as a heat sink. Referring to Fig. 2B, the projections 19 extend parallel to one side of the second electrode 15. The ends of each projection 19 reach the edges of the second electrode 15. In other words, the length of each projection 19 is equal to the width of the second electrode 15. Further, each projection 19 has a rectangular cross-section. As shown in Fig. 2B, the height of each projection 19 is greater than the thickness of the second electrode 15. In drawings other than Fig. 2B, the projections 19 are shown with a height that is about the same as the thickness of the second electrode 15.

The formation of the projections 19 will now be discussed. A flat film having a predetermined thickness is formed by performing, for example, vacuum vapor deposition. Then, the projections 19 are formed integrally with the flat film (second electrode 15) by performing vacuum vapor deposition with a shadow mask having a number of elongated holes formed in correspondence with the locations of the projections 19. Metal, such as aluminum, is deposited on the upper surface of the flat film at locations corresponding to the elongated holes of the shadow mask to form the projections 19.

The operation of the organic EL device 11 will now be discussed. The organic EL device 11 is used, for example, as a backlight for a liquid crystal display.

When using the organic EL device 11, the first connection terminals 13a and the second connection terminal 15a are connected to an external line, such as an anisotropic conductive film (ACF), which leads to a drive circuit (not shown) that drives the organic EL device 11.

The drive circuit supplies current to the first electrode 13 via the first connection terminals 13a. The resistivity of the material forming the first electrode 13 (transparent electrode) is greater than that of metal having relatively high conductivity, such as aluminum and copper. Thus, when current is supplied to the first end of the first electrode 13 only from the first connection terminals 13a, a large amount of current flows from the first electrode 13 to the second electrode 15 through the organic EL layer 14 near the first connection terminals 13a. However, at portions separated from the first connection terminals 13a, the amount of current flowing from the first electrode 13 to the second electrode 15 is small. As a result, brightness unevenness would occur in the organic EL device 11. To solve this problem, in the present embodiment, the conductive film 17, which has relatively high conductivity, is connected to the first end and second end 13b of the first electrode 13. The second end 13b is located farthest from the first connection terminals 13a. Thus, the difference between the amount of current flowing through the organic EL layer 14 near the first connection terminals 13a and the amount of current flowing through the organic EL layer 14 at a location farthest from the first connection terminals 13a is small. This minimizes brightness unevenness in the organic EL device 11. Further, the conductive layer 17, which covers the organic EL layer 14, uniformly radiates the heat of the organic EL layer 14 and improves the brightness unevenness minimizing effect.

The conductive film 17 functions to supply current to different portions of the first electrode 13. Thus, the conductive film 17 must be insulated from the second electrode 15. The conductive film 17 is located at the outer side of the protective film 16, which is located between the conductive film 17 and the second electrode 15. Thus, the conductive film 17 and the second electrode 15 are insulated from each other.

The organic EL device 11 is driven by current. The current that flows through the organic EL layer 14 produces heat in the organic EL layer 14. Excess heat would affect the luminescence characteristics of the organic EL device 11 in an undesirable manner and shorten the life of the organic EL device 11. Thus, to efficiently radiate the heat produced in the organic EL layer 14, the projections 19 are formed on the surface of the second electrode 15.

The protective film 16 is in close contact with the second electrode 15 and the projections 19. Further, the protective film 16, the conductive film 17, and the insulation film 18 are in close contact with each other. Thus, the heat of the organic EL layer 14 is efficiently radiated through the second electrode 15 and the projections 19. If a shielding cover that defines a space around the projections 19 of the second electrode 15 were to be used and gas or liquid were to be charged into the space, heat would not be radiated from the second electrode 15 in a satisfactory manner. Thus, such a structure is not preferable.

The first embodiment has the advantages described below.
(1) The transparent first electrode 13, the organic EL layer 14, and the metal second electrode 15 are sequentially superimposed on the glass substrate 12. Further, the protective film 16, which protects the organic EL layer 14 from oxygen and moisture, covers the second electrode 15. In addition, the projections 19 are formed on the second electrode 15 on the surface facing away from the organic EL layer 14. Therefore, in comparison to the prior art in which inert gas or liquid is charged into a sealed space formed in a shielding cover to radiate heat from an electrode (refer to Figs. 5 and 6), the heat of the organic EL layer 14 is efficiently radiated out of the organic EL device 11. Since the shielding cover is not necessary, a thin organic EL device 11 may be manufactured.
(2) The protective film 16 is a coated film. If vapor deposition or sputtering were to be performed to form the protective film 16, it would be difficult to cover the projections 19 formed on the surface of the second electrode 15 without any gaps. However, since the protective film 16 is a coated film, the surface of the projections 19 are covered without any gaps when forming the protective film 16.
(3) The organic EL device 11 is a bottom emission type device. Thus, the organic EL device 11 may be attached to a frame so that an outer surface of the organic EL device 11 facing away from the glass substrate 12 contacts the frame. This would improve the heat radiation effect.
(4) The conductive film 17, which covers the second electrode 15, is insulated from the second electrode 15 at the outer side of the protective film 16. The first end portion 17a of the conductive film 17 is connected to the first end of the first connection terminals 13a of the first electrode 13. The second end portion 17b of the conductive film 17 is connected to the second end 13b of the first electrode 13 on the opposite side of the connection terminals 13a. Thus, the preferred embodiment differs from the prior art in which an auxiliary electrode is formed near the first electrode 13 to minimize brightness unevenness of the organic EL layer 14. That is, an insulation film for insulating an auxiliary electrode from the second electrode 15 is not necessary. This decreases the manufacturing cost. Further, the difference between the amount of current flowing through the organic EL layer 14 at portions close to the first connection terminals 13a of the first electrode 13 and at portions far from the first connection terminals 13a minimizes brightness unevenness in the entire organic EL device 11. Additionally, since the conductive film 17 covers the organic EL layer 14, the heat produced in the organic EL layer 14 is uniformly radiated. This improves the brightness unevenness minimizing effect.
(5) The conductive film 17 is formed on the protective film 16 by performing vapor deposition. This improves adhesion between the conductive film 17 and the protective film 16 in comparison to when adhering a metal foil to the protective film 16 as the conductive film 17. Further, the conductive film 17 uniformly radiates the heat produced by the organic EL layer 14 and improves the brightness unevenness minimizing effect.
(6) The first end portion 17a of the conductive film 17 is connected to the first end of the first connection terminals 13a of the first electrode 13. The second end portion 17b of the conductive film 17 is connected to the second end 13b of the first electrode 13 on the opposite side of the connection terminals 13a. Accordingly, the conductive film 17 does not have to be connected to the first electrode 13 on a side adjacent to the side connected to the first connection terminals 13a. This decreases the area of non-luminescent portions of the glass substrate 12 without affecting the effective luminescent area of the glass substrate 12. The "effective luminescent area" refers to the area of the glass substrate 12 out of which the light of the organic EL layer 14 is emitted.
(7) The conductive film 17 is a metal film. Thus, the conductive film 17 functions to prevent oxygen and moisture in ambient air from entering the organic EL device 11 and functions as a passivation film.
(8) The conductive film 17 is covered by the insulation film 18, which is made of the same material as the protective film 16. Thus, the insulation film 18 and the protective film 16 may be formed through the same method. This facilitates the manufacturing of the organic EL device 11.
(9) The insulation film 18 is formed on the outer side of the conductive film 17. This prevents short-circuiting that may occur if the conductive film 17 comes into contact with electronic components when attaching the organic EL device 11 to a frame.
(10) The conductive film 17 is a vapor deposition film made of aluminum. Thus, the conductive film 17 is easier to form than when it is made of another metal such as copper.
(11) The second electrode 15 is made of metal to reflect light. Thus, some of the light of the organic EL layer 14 is reflected by the second electrode 15 and emitted from the glass substrate 12. Accordingly, in comparison to when the second electrode 15 is not reflective, the amount of light emitted from the glass substrate 12 is increased.
(12) The area of the upper surface of the organic EL layer 14 is greater than the area of the lower surface of the second electrode 15. Since the area of the upper surface of the organic EL layer 14 and the area of the lower surface of the second electrode 15 are not the same, short-circuiting between the first electrode 13 and the second electrode 15 is easily prevented.
(13) A shadow mask is used to form the projections 19 on the second electrode 15 from the same material as the second electrode 15. This forms the projections 19 on the second electrode 15 without damaging the organic EL layer 14, which is formed through vapor deposition. If, for example, parts of the second electrode 15, formed through vapor deposition with a predetermined thickness, were to be etched to form the projections 19, there would be a possibility of the organic EL layer 14 being damaged.
   An organic EL device 11 according to a second embodiment of the present invention will now be discussed with reference to Fig. 3. The conductive film 17 and the insulation film 18 of Fig. 1C are eliminated in the second embodiment. Further, a metal auxiliary electrode 20, which is connected to first connection terminals 13a, is formed on the peripheral portion of a first electrode 13, which is formed on a glass substrate 12. An insulation film 21 is formed on the auxiliary electrode 20. An organic EL layer 14 covers the first electrode 13 and the insulation film 21. A second electrode 15 is formed on the organic EL layer 14. A protective film 16 is formed on the outer side of the second electrode 15 to protect the organic EL layer 14 from oxygen and moisture.
   After the first electrode 13, the first connection terminals 13a, and a second connection terminal 15a are formed on the glass substrate 12, the auxiliary electrode 20 is formed by performing, for example, vapor deposition. Projections 19 are formed on the second electrode 15 at positions corresponding to the inner side of the auxiliary electrode 20.
   In addition to advantages (1) to (3), (11), and (13) of the first embodiment, the second embodiment has the advantages described below.
(14) The auxiliary electrode 20, of which resistance is less than that of the first electrode 13, is formed on the peripheral portion of the first electrode 13. In comparison to when there is no auxiliary electrode 20, the auxiliary electrode 20 minimizes brightness unevenness resulting from different resistivities of the materials forming the first electrode 13 and the second electrode 15.

It should be apparent to those skilled in the art that the present invention may be embodied in many other specific forms without departing from the spirit or scope of the invention. Particularly, it should be understood that the present invention may be embodied in the following forms.

The organic EL device 11 does not necessarily have to be provided with the conductive film 17 and the insulation film 18 or with the auxiliary electrode 20. For example, as shown in Fig. 4, in a normal organic EL device 11 that does not have these members, the protective film 16 may be formed on the projections 19 of the second electrode 15. In this case, the heat produced by the organic EL layer 14 is efficiently radiated out of the organic EL device 11 via the second electrode 15 and the projections 19.

The protective film 16 does not necessarily have to fill the gaps between the projections 19 to form an even surface. For example, when the organic EL device 11 does not include the conductive film 17 and the insulation film 18, the protective film 16 may be a relatively thin film spreading along the surface of the projections 19, as shown in Fig. 4. The uneven protective film 16 has an increased surface area. This improves the heat radiation effect.

The cross-sectional shape of each projection 19 does not have to be rectangular. Further, the length of each projection 19 does not have to be substantially the same as the width of the second electrode 15. For example, each projection 19 may have substantially the same length as the width of the electrode 15 but have a triangular or semicircular cross-section. Alternatively, the ends of each projection 19 do not have to reach the edges of the second electrode 15. Further, each projection 19 does not have to extend parallel to or orthogonal to one side of the second electrode 15. For example, each projection 19 may extend diagonal to one side of the second electrode 15. Further, adjacent projections 19 do not have to be parallel to each other and may extend in different directions.

The projections 19 may be shaped into folds so that the projections 19 form, for example, a corrugated surface. Such a structure would prevent cracks from being produced in the protective film 16 at locations corresponding to the corners of the projections 19.

Each of the projections 19 may be box-shaped, cylindrical, pyramidal, conical, frustopyramidal, frustoconical, or semispherical. In such cases, if the total area of the bottom surfaces of the projections 19 is the same as that of the projections 19 of Fig. 2B, the total surface area of the projections is increased. This improves the heat radiation effect.

Instead of forming projections 19 on the second electrode 15, recesses may be formed in the second electrode 15. Alternatively, the second electrode 15 may have both projections and recesses. Normally, the formation of the projections 19 is easier than the formation of recesses. To form the recesses in the surface, vapor deposition is performed using a shadow mask when forming the second electrode 15. This forms the second electrode 15 and the recesses without damaging the organic EL layer 14. If the recesses were to be formed by etching parts of the second electrode 15, this may damage the organic EL layer 14.

Instead of coating a fluid material to form the protective film 16, vapor deposition may be performed to form the protective film 16. A material having little transmissivity with respect to moisture or gases, such as oxygen, is vapor deposited to form the protective film 16. Such a material may be silicon nitride, silicon oxide, or diamond-like carbon (DLC). Alternatively, the protective film 16 may be formed by superimposing a plurality of thin films made of different materials. When performing vapor deposition to form the protective film 16, it is preferred that the posture of the glass substrate 12 be adjusted so that the vapor deposited substance is deposited from various directions on the first electrode 13, the organic EL layer 14, and the second electrode 15.

The first electrode 13 formed on the glass substrate 12 may function as a cathode and the second electrode 15 may function as an anode: In this case, the structure of the organic EL layer 14 is changed accordingly. For example, the organic EL layer 14 may include from the side closer to the first electrode 13, the three layers of an electron injection layer, a luminescence layer, and a hole injection layer. Alternatively, the organic EL layer 14 may include from the side closer to the first electrode 13, the five layers of an electron injection layer, an electron transport layer, a luminescence layer, a hole transport layer, and a hole injection layer.

The organic EL layer 14 may be formed from a single luminescence layer. Alternatively, the organic EL layer 14 may be formed from a plurality of layers by superimposing on a luminescence layer one or more of a hole injection layer, a hole transport layer, a hole injection transport layer, a hole restriction layer, an electron injection layer, an electron transport layer, and an electron restriction layer.

The organic EL device 11 does not have to be used as a backlight and may be used as another type of lighting device, a light source for a display device, or as an EL display device. For example, when using the organic EL device 11 in a display device driven in compliance with the active matrix technique, the organic EL device 11 may include a plurality of first electrodes 13 and a single second electrode 15. The first electrodes 13 each function as an independent anode, and the single second electrode 15 functions as a cathode for all of the first electrodes 13. The first electrodes 13 may be arranged in a matrix array. Each first electrode 13 is supplied with current via a thin film transistor (TFT), a thin film diode (TFD), or a metal insulated metal (MIM). A plurality of projections 19 are formed on the second electrode 15. This improves the heat radiation efficiency of the display device.

The second connection terminal 15a of the second electrode 15 does not have to be arranged on the same side of the glass substrate 12 as the first connection terminals 13a of the first electrode 13. For example, the second connection terminal 15a may be arranged on the side of the glass substrate 12 that is adjacent to the first connection terminal 13a.

The first end portion 17a of the conductive film 17 may be directly connected to the first connection terminals 13a of the first electrode 13.

When the organic EL device 11 is used for a display device, the substrate may be formed by superimposing color filters on a transparent substrate.

A transparent resin substrate may be used in lieu of the glass substrate 12. The resin substrate may be flexible. A resin substrate is advantageous when reducing the weight of the organic EL device 11.

The conductive film 17 may be connected to a square, first electrode 13 at a first side, which is connected to the connection terminals 13a, a second side located on the opposite side of the connection terminals 13a, and the sides adjacent to the first connection terminals 13a. This further reduces brightness unevenness.

The second electrode 15 does not have to reflect visible light. However, when the second electrode 15 is reflective, light from the organic EL layer 14 is reflected by the second electrode 15 and emitted out of the glass substrate 12. Thus, in comparison to when the second

## Claims

1. An organic electroluminescence device (11) including:
a substrate (12) for transmitting visible light;
a first electrode (13), superimposed on the substrate, for transmitting visible light;
an organic electroluminescence layer (14) superimposed on the first electrode;
a second electrode (15) superimposed on the organic electroluminescence layer, the second electrode including a first surface facing towards the organic electroluminescence layer, a second surface facing away from the organic electroluminescence layer; and
a protective film (16), covering the second electrode, for protecting the organic electroluminescence layer, the organic electroluminescence device being **characterized by**:
at least either one of a plurality of projections or a plurality of recesses arranged along the second surface of the second electrode.

2. The organic electroluminescence device according to claim 1, wherein the protective film is a coated film.

3. The organic electroluminescence device according to claim 1, wherein the protective film is adjacent to the second electrode.

4. The organic electroluminescence device according to claim 1, wherein the protective film is in close contact with the second electrode.

5. The organic electroluminescence device according to claim 1, wherein the at least either one of a plurality of projections or a plurality of recesses are formed integrally with the second electrode.

6. The organic electroluminescence device according to any one of claims 1-5, wherein the first electrode has a first end including a connection terminal (13a) and a second end (13b) located on the opposite side of the first end, the organic electroluminescence device further **characterized by**:
a conductive film (17) covering the protective film and the second electrode, the conductive film being insulated from the second electrode and being connected to the first and second ends of the first electrode.

7. The organic electroluminescence device according to any one of claims 1-5, further **characterized by**:
an auxiliary electrode (20) located at an outer side of the first electrode, the auxiliary electrode being connected to the first electrode and having a resistance that is less than that of the first electrode.
